# EUROPÄISCHE PATENTANMELDUNG

(11) **EP 1 681 732 A2**
(43) Veröffentlichungstag der Anmeldung: **19.07.2006**
(21) Anmeldenummer: 06000487.6
(22) Anmeldetag: 11.01.2006
(51) Int. Cl.: H01L 45/00

(54) **Speichervorrichtung und Herstellungsverfahren**

(30) Priorität: 12.01.2005 DE 102005001460
(71) Anmelder: Infineon Technologies AG, 81669 München (DE)
(72) Erfinder: Happ, Thomas, Tarrytown, NY 10591 (US)
(74) Vertreter: Reinhard - Skuhra - Weise & Partner

(57) **Zusammenfassung**

Die erfindungsgemäße Speichervorrichtung mit einer Zelle 14 weist in einem ersten Zustand einen hohen elektrischen Widerstand und in einem zweiten Zustand einen geringen elektrischen Widerstand auf. Die Zelle 14 weist einen Randbereich 16 und einen Kernbereich 15 auf, wobei im zweiten Zustand ein spezifischer elektrischer Widerstand in dem Randbereich 16 größer als in dem Kernbereich 15 ist.

## Beschreibung

Die vorliegende Erfindung betrifft eine Speichervorrichtung und ein Herstellungsverfahren einer Speichervorrichtung.

Speicherzellen werden u.a. durch ihre Zellgröße, Flüchtigkeit der gespeicherten Information und Auslesesicherheit charakterisiert. Dabei besteht der Wunsch Speicherzellen zu entwickeln, welche ein geringeres Volumen einnehmen, um eine höhere Integrationsdichte mit den allgemein bekannten Vorteilen zu erlangen; die herkömmlichen flüchtigen Speicherzellen, wie DRAMs, durch nichtflüchtige Speicherzellen zu ersetzen und die Auslesesicherheit zu verbessern, indem ein Signalunterschied zwischen den binären Zuständen (high, low) erhöht wird.

Obwohl die vorliegende Erfindung mit Bezug auf Phasenwechselspeicherzellen (PC-RAM, phase change RAM) auch Ovonic Unified Memory (OUM)-Zellen genannt, beschrieben wird, ist die vorliegende Erfindung nicht darauf beschränkt, sondern betrifft allgemein Speichervorrichtungen und Herstellungsverfahren.

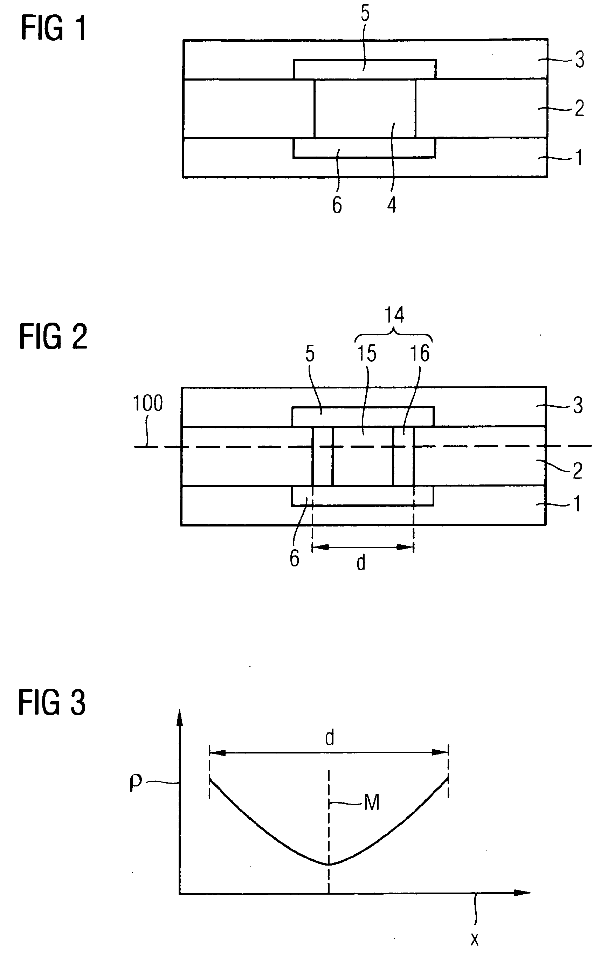

Ein Konzept von Speicherzellen, welches gegenüber den herkömmlichen Speicherzellen in DRAM-, SRAM- oder Flash-Speicherzellen in den vorgenannten Eigenschaften überlegen ist, sind die so genannten OUM-Speicherzellen, welche auch als Phase Change Random Access Memory (PCRAM) bezeichnet werden. Mit Bezug auf Fig. 1 ist schematisch der Aufbau einer PC-RAM dargestellt. Zwischen zwei Kontaktbereichen 5 und 6 ist eine Speicherzelle 4 angeordnet, welche aus Ge₂Sb₂Te₅ (GST) gebildet ist. Die Information wird in dieser Speicherzelle 4 in Form des elektrischen Widerstands codiert, sprich ein hoher Widerstand entspricht z.B. der logischen Null, und ein entsprechend niedriger Widerstand der logischen Eins. Der spezifische Widerstand von GST ist in der amorphen Phase höher als in kristalliner Phase. Durch Erhitzen von GST bis zu einer Kristallisationstemperatur bei etwa 420°C wechselt GST von dem Zustand einer amorphen Phase in den Zustand einer kristallinen Phase. Der umgekehrte Prozess wird durch Erhitzen von GST bis über dessen Schmelztemperatur bei etwa 620°C hinaus erreicht, wobei sich bei einer schnellen Abkühlung der Zustand einer amorphen Phase ausbildet. Zweckmäßigerweise ist GST bis zu Temperaturen bei 100°C sowohl in der Glasphase als auch in der kristallinen Phase für mehr als 10 Jahre stabil. Damit eignen sich Speicherzellen aus GST für nichtflüchtige Speicherbauelemente, welche in einfacher Weise durch Bestimmen ihres Widerstands ausgelesen werden können. Die notwendige Wärmeleistung für die Überführung zwischen den beiden Phasen erfolgt zweckmäßigerweise mit einem Heizstrom, welcher durch die Speicherzelle fließt und welcher mittels eines Transistor gesteuert wird. Um die erforderliche Schmelztemperatur zu erreichen, muss der Transistor so ausgelegt sein, dass er den dafür notwendigen Heizstrom schalten kann. Hierbei zeigt sich, dass die Abmessungen des entsprechenden Transistors die Integrationsdichte eines Speicherbauelements limitieren.

Das Aufheizen der Speicherzelle bis zur Schmelztemperatur erfolgt nicht homogen über die Speicherzelle 4. GST weist gegenüber den die Speicherzelle umgebenden Materialien der Kontaktierungsbereiche und der Einbettung 2 eine geringe thermische Leitfähigkeit auf. Dies führt dazu, dass die Randbereiche der Speicherzelle durch den thermischen Kontakt mit der Einbettung 2 abkühlen, während ein thermischer Ausgleich innerhalb der Speicherzelle aufgrund der geringen thermischen Leitfähigkeit nur bedingt erfolgt. Dies führt dazu, dass bei einem Aufheizen mit einem relativ geringen Strompuls nur in einem inneren Bereich der Speicherzelle 4 die Schmelztemperatur erreicht wird. Die äußeren radialen Randbereiche, welche in Kontakt mit der Einbettung 2 stehen, erreichen nicht die für den Wechsel in die amorphe Phase notwendige Temperatur. Dies reduziert den maximal erreichbaren Widerstandswert der Speicherzelle, da parallel zu dem hochohmigen, glasförmigen inneren Bereich niederohmige kristalline Randbereiche vorhanden sind. Nachteiligerweise ergibt sich somit ein reduzierter Signalunterschied zwischen den beiden Widerstandswerten der Speicherzelle und damit eine geringere Auslesesicherheit. Eine beliebige Erhöhung des Heizstroms, um auch die äußeren Bereiche über die Schmelztemperatur aufzuheizen, ist aus Gründen der bereits erläuterten Problematik der Integrationsdichte des den Heizstrom steuernden Transistors nicht möglich.

Es ist eine Aufgabe der vorliegende Erfindung, eine Halbleiterspeichervorrichtung bereitzustellen, welche bei einem geringen Heizstrom einen großen Signalunterschied ermöglicht. Zudem ist es eine Aufgabe, ein Herstellungsverfahren bereitzustellen, mit welchem eine entsprechende Speichervorrichtung hergestellt werden kann.

Die vorgenannten Aufgaben werden durch die Speichervorrichtung mit den im Patentanspruch 7 genannten Merkmalen und dem Herstellungsverfahren mit den im Patentanspruch 1 genannten Merkmalen gelöst.

Eine Idee der vorliegenden Erfindung ist, einen Randbereich einer Speicherzelle so einzurichten, dass er einen höheren Widerstand als ein Kernbereich der Zelle aufweist. Ein vollständiges Umwandeln des Randbereichs von dem niederohmigen, kristallinen Zustand in den hochohmigen, glasförmigen Zustand wird dadurch kompensiert, dass der äußere Bereich immer einen deutlich höheren spezifischen Widerstand als der Kernbereich aufweist.

Die erfindungsgemäße Speichervorrichtung mit mindestens einer Zelle weist in einem ersten Zustand einen hohen elektrischen Widerstand und in einem zweiten Zustand einen geringen elektrischen Widerstand auf. Die Zelle weist einen Randbereich und einen Kernbereich auf, wobei im zweiten Zustand ein spezifischer elektrischer Widerstand in dem Randbereich größer als in dem Kernbereich ist.

Das erfindungsgemäße Herstellungsverfahren sieht vor, ein aktives Material auf einem Trägersubstrat aufzubringen und zu strukturieren, so dass ein Rohkörper einer Zelle ausgebildet wird. Verunreinigungen werden in den Rohkörper derart eingebracht, dass eine Konzentration der Verunreinigung in einem Randbereich größer als in einem Kernbereich des Rohkörpers ist. Dadurch wird aus dem Rohkörper die Zelle gebildet, welche im Randbereich eine geringere spezifische, elektrische Leitfähigkeit aufweist.

In den Unteransprüchen werden Weiterbildungen und Ausgestaltungen der vorliegenden Erfindung beschrieben.

Gemäß einer Ausgestaltung der vorliegenden Erfindung nimmt die Konzentration der Verunreinigungen kontinuierlich vom Randbereich zu dem Kernbereich hin zu.

Gemäß einer Ausgestaltung der vorliegenden Erfindung enthalten die Verunreinigungen Sauerstoff und/oder Stickstoff und/oder Silizium. Insbesondere Stickstoff eignet sich, um in moderaten Konzentrationen den spezifischen Widerstand von Chalkogenen, wie Ge₂Sb₂Te₅, welches typischerweise als aktives Material verwendet wird, zu erhöhen.

Gemäß einer Weiterbildung des vorliegenden Verfahrens erfolgt das Einbringen der Verunreinigungen durch ein Diffundieren aus einer die Verunreinigungen enthaltenden Atmosphäre. Auf diese Weise lassen sich in einfacher Weise die Verunreinigungen einbringen und durch Kontrolle der Atmosphäre, Konzentration der Verunreinigungen in der Atmosphäre, Druck, Temperatur das Konzentrationsprofil in der Zelle steuern.

Gemäß einer weiteren Weiterbildung werden die Verunreinigungen senkrecht zu dem Randbereich oder aus einer Richtung mit einem Winkel zu dem Randbereich implantiert. Hierbei können u.a. plasmaunterstützte Implantationsverfahren verwendet werden.

Gemäß einer Ausgestaltung der vorliegenden Erfindung ist ein aktives Material in der Zelle in einem ersten Zustand im Kernbereich amorph und in einem zweiten Zustand in der Zelle kristallin.

Gemäß einer Weiterbildung der vorliegenden Erfindung nimmt der spezifische elektrische Widerstand im zweiten Zustand kontinuierlich von dem Randbereich zum Kernbereich zu.

Gemäß einer Ausgestaltung der vorliegenden Erfindung ist der Randbereich im ersten Zustand teilweise kristallin.

Bevorzugte Ausführungsformen der vorliegenden Erfindung werden mit Bezug auf die Figuren erläutert. In den Figuren zeigen:
- Fig. 1: eine Speicherzelle zur Erläuterung der vorliegenden Problematik;
- Fig. 2: eine schematische Querschnittsansicht einer Ausführungsform der vorliegenden Erfindung;
- Fig. 3: eine graphische Darstellung eines Profils eines spezifischen Widerstands gemäß einer Ausführungsform der vorliegenden Erfindung;
- Fig. 4 bis 8: schematische Querschnitte zur Erläuterung einer Ausführungsform des erfindungsgemäßen Herstellungsverfahrens; und
- Fig. 9: eine schematische Querschnittsansicht einer dritten Ausführungsform der vorliegenden Erfindung.

In den Figuren bezeichnen gleiche Bezugszeichen gleiche oder funktionsgleiche Einrichtungen.

Fig. 2 zeigt schematisch eine Querschnittsansicht einer Ausführungsform der erfindungsgemäßen Speichervorrichtung. Eine Zelle 14 ist zwischen zwei gegenüberliegenden Kontaktbereichen 5, 6 angeordnet. Die Zelle 14 weist einen Kernbereich 15 und einen äußeren Randbereich 16 auf, wobei in der dargestellten Ausführungsform jeder der Bereiche 15, 16 den unteren Kontaktbereich 6 mit dem oberen Kontaktbereich 5 verbindet. Mit anderen Worten, der Randbereich 16 entspricht im Wesentlichen dem Umfang der Zelle 14, welcher nicht parallel zu den Kontaktflächen 5, 6 verläuft. Der untere Kontaktbereich 6 ist in einem Trägersubstrat 1 eingebettet, in welchem weitere Halbleiterstrukturen angeordnet sein können. Der Randbereich 16 der Zelle 14 ist von einer Einbettung 2 aus einer Füllmasse umgeben, welche auf dem Trägersubstrat 1 aufgebracht ist. Die Einbettung 2 und der obere Kontaktbereich 5 sind mit einer Deckschicht 3 überzogen, in welcher weitere Strukturen eingebracht oder auf welcher Strukturen aufgebracht werden können. Die Zelle 14 weist ein aktives Material auf, welches aus der Gruppe der Chalkogenide ausgewählt ist. Ein besonders bevorzugtes Material ist Ge₂Sb₂Te₅, jedoch sind auch andere Materialien, wie z.B. AgInSeTe verwendbar. Die Chalkogenide zeichnen sich durch eine metastabile Glasphase bei Temperaturen bis zu 100°C aus. Der stabile Zustand der Chalkogenide weist eine kristalline Phase auf. Ein Wechsel von der Glasphase, auch als amorphe Phase bezeichnet, zu der kristallinen Phase erfolgt durch Aufheizen der Chalkogenidverbindung bis zu einer Kristallisationstemperatur. Nach einem Überschreiten dieser Kristallisationstemperatur, ca. 420°C für GST, und dortigem Verweilen für eine gewisse Zeit (z.B. 50 ns) kristallisiert das Chalkogenid. Durch Aufschmelzen des Chalkogenids und einem nachfolgenden raschen Abkühlen erstarrt das Chalkogenid in der Glasphase. Die Schmelztemperatur von GST liegt bei etwa 620°C. Das rasche Abkühlen wird durch die Kontaktflächen 5, 6 sowie die Einbettung 2 erreicht. Bei den typischen Abmessungen d der Zelle 14 von 50 nm wird die Glasphase innerhalb von 1 ns erreicht. Die Dauer für eine vollständige Kristallisation des Chalkogenids der Zelle 14 liegt im Größenbereich von 10 ns - 50 ns. Interessant für die Verwendung als Speicherzelle ist, dass die beiden Phasen, nachfolgend auch als Zustände bezeichnet, bei typischen Betriebstemperaturen eines Halbleiterbauelements stabil sind und sich somit nicht ändern. Zudem ist ein Wechsel zwischen den beiden Zuständen nur durch Heizen erreichbar.

Der Zustand der Zelle 14 bzw. die Phase des aktiven Materials kann über den unterschiedlichen spezifischen Widerstand der kristallinen und der Glasphase bestimmt werden. In der kristallinen Phase weist das Chalkogenid typischerweise einen spezifischen Widerstand von 10⁻³ bis 10⁻² Ωcm und in der amorphen Phase einen um bis zu dem Faktor 100 - 1000 größeren spezifischen Widerstand auf. Durch Messen des Widerstands der Zelle 14 zwischen den beiden Kontaktflächen 5, 6 wird somit der Zustand der Zelle bestimmt.

Die Heizleistung zum Ändern der Phase, also von der amorphen in die kristalline Phase (Set) und von der kristallinen in die amorphe Phase (Reset), wird durch einen Heizstrom durch die Kontaktflächen 5, 6 zugeführt. In der Zelle 14 stellt sich dabei ein dynamisches Gleichgewicht der Temperaturverteilung ein. In dem Kernbereich 15 ergibt sich eine höhere Temperatur als in dem Randbereich 16, da der Randbereich mit dem großen Wärmereservoir der Einbettung 2 in Kontakt ist und eine Umverteilung der Wärmemenge innerhalb der Zelle 14 aufgrund der geringen Wärmeleitfähigkeit der Chalkogenide in zu geringem Maße stattfindet, um die Wärmeverluste in dem Randbereich 16 der Zelle 14 zu kompensieren. Dies hat zur Folge, dass die äußeren Bereiche nur bei sehr hohen Heizströmen bis zur Schmelztemperatur aufgeheizt werden können und somit im wesentlichen permanent in dem niederohmigen kristallinen Zustand vorliegen. Der Gesamtwiderstand der Zelle 14 im hochohmigen Zustand setzt sich somit zusammen aus dem hochohmigen Widerstand 15 des Kernbereiches 15 und dem niedrigohmig verbleibenden Widerstand des Randbereichs 16. Dies begrenzt den maximal erreichbaren Widerstand der Zelle und damit auch den Kontrast zwischen dem hochohmigen und dem niederohmigen Zustand der Zelle 14.

In der bevorzugten Ausführungsform der vorliegenden Erfindung ist deshalb der spezifische elektrische Widerstand p in einem Randbereich 16 größer als in einem Kernbereich 15. In Fig. 3 ist dazu eine graphische Auftragung des spezifischen Widerstandes p gegenüber einer horizontalen Achse X, welche in einer zu den Kontaktflächen 5, 6 parallelen Querschnittsfläche 100 liegt, aufgetragen. M bezeichnet die Mitte des Kernbereichs 15 und d die Breite der gesamten Zelle 14. Der Unterschied des spezifischen Widerstands in einem Außenbereich zu einem Kernbereich kann durchaus zwei Größenordnungen betragen und somit dem Unterschied des spezifischen Widerstands p zwischen der amorphen und der Glasphase entsprechen. Die Auftragung des spezifischen Widerstands p in Fig. 3 ist für die kristalline Phase der Zelle 14 dargestellt. Im niederohmigen Zustand der Zelle 14 ergibt sich durch die Erhöhung des spezifischen Widerstands p in den Randbereichen nur eine geringe Erhöhung des Gesamtwiderstandes der Zelle 14. Jedoch führt die Erhöhung in dem Randbereich 16 zu einem wesentlich höheren Gesamtwiderstand der Zelle 14 im hochohmigen Zustand gegenüber einer Zelle mit einem niederohmigen kristallinen Randbereich. In Differenz erhöht sich somit der Unterschied zwischen dem hochohmigen und dem niederohmigen Gesamtwiderstand. Damit erhöht sich vorteilhafterweise die Auslesesicherheit aufgrund der erhöhten Unterscheidbarkeit der beiden Zustände.

Ein weiterer Vorteil der Ausführungsform ist, dass man den Heizstrom senken kann, da amorphe Randbereiche, wie oben erläutert, einen geringeren Einfluss auf die Auslesesicherheit haben. Die Folge ist, dass ein Transistor, welcher den Heizstrom schaltet, mit geringeren Abmessungen angeordnet wird. Da die Größe dieser Transistoren der hauptsächlich limitierende Faktor für die Integrationsdichte dieser Speicherzellenanordnungen ist, ist eine Reduzierung der Abmessungen dieser Transistoren sehr erstrebenswert.

Ein weiterer Vorteil der geringeren benötigten Heizleistung ist, dass ein Speichermodul mit den vorgenannten Zellen 14 beim Schreiben und Löschen weniger Abwärme erzeugt. Somit kann die thermische Belastung benachbarter Bauelemente verringert werden. Außerdem wird - insbesondere in mobilen Applikationen - die Batterielebensdauer verlängert.

Das in Fig. 3 dargestellte Profil des spezifischen Widerstands p ist nur beispielhaft. Unter Berücksichtigung einer Wärmetransportgleichung, der zu erreichenden Schmelztemperatur und dem angestrebten Unterschied der Gesamtwiderstände im hochohmigen und niederohmigen Zustand kann ein optimales Profil berechnet werden. Durch Erhöhen bzw. Absenken der Konzentration der Verunreinigungen in der umgebenden Atmosphäre wird die Konzentration im Randbereich der Zelle 14 gesteuert. Mittels eines Temperaturprofil über einen Zeitraum wird die Diffusionsgeschwindigkeit und der Diffusionstransport der Verunreinigungen in der Zelle gesteuert und somit das gewünschte optimale Profil eingestellt.

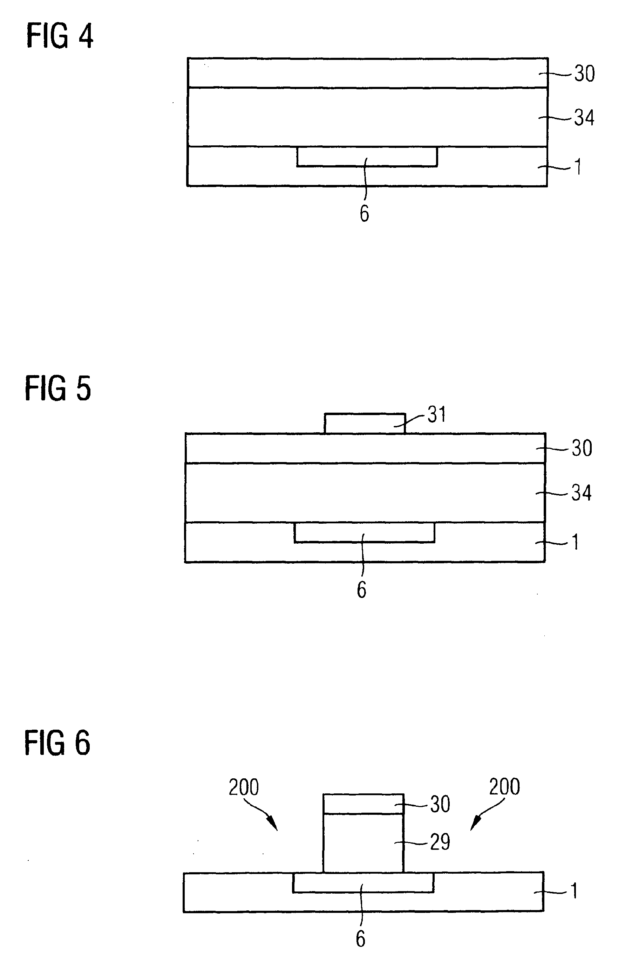

In den Figuren 4 bis 8 ist schematisch eine Ausführungsform des erfindungsgemäßen Herstellungsverfahrens dargestellt. Auf einem Trägersubstrat 1 mit einem Kontaktbereich 6 wird ein aktives Material 34 aufgebracht. Dies kann u.a. mit Hilfe eines Sputter-Prozesses erfolgen. Typische Materialien sind, wie bereits zuvor genannt, Chalkogene. Auf das aktive Material 34 wird eine Hartmaske, z.B. aus Siliziumoxid, abgeschieden (siehe Fig. 4). Durch Aufbringen einer Lackschicht 31, einem lithographischen Schritt sowie ggf. geeignete Spacer- bzw. Rückätz-Techniken zum Erzielen sublithografischer Dimensionen und einem Ätzen wird die Hartmaske 30 und das aktive Material 34 strukturiert, so dass eine Zelle 24 oberhalb des Kontaktbereichs 6 gebildet wird. In Fig. 6 ist dargestellt, dass ein Rest der Hartmaske 30 eine obere Fläche der Zelle 24 nach dem Strukturierungsprozess noch bedeckt.

Die Zelle 24 wird bei erhöhter Temperatur einer Atmosphäre mit Stickstoff und/oder Sauerstoff ausgesetzt. Die Sauerstoff- bzw. Stickstoffmoleküle diffundieren in die Zelle 24. Die Konzentration dieser Verunreinigungen nimmt von dem Randbereich 26 zu dem Kernbereich 25 hin ab. Dies stellt sich selbstorganisierend aufgrund der begrenzten Diffusionsgeschwindigkeit der Verunreinigungen in dem aktiven Material 34 ein. Die Sauerstoff- und insbesondere die Stickstoffverunreinigungen erhöhen den spezifischen Widerstand des chalkogenhaltigen aktiven Materials 34. Da die Konzentration der Verunreinigungen in dem Randbereich, wie zuvor beschrieben, höher ist als im Kernbereich, ist entsprechend, wie gewünscht, auch der spezifische Widerstand p in dem Randbereich 26 höher als in dem Kernbereich 25.

Durch den verbleibenden Rest der Hartmaske 30 wird die obere Fläche vor einem Eindiffundieren der Verunreinigungen geschützt. In einer weiteren Ausführungsform kann auf die Deckschicht 30 verzichtet werden, wenn auch der spezifische Widerstand in der oberen Deckfläche der Zelle 24 erhöht werden soll. Dies kann notwendig sein, wenn die Schmelztemperatur des aktiven Materials 34 in der Nähe des Kontaktbereichs 6 aufgrund einer großen Wärmeabfuhr nicht erreicht wird und somit keine amorphe Phase in diesem Bereich generierbar ist.

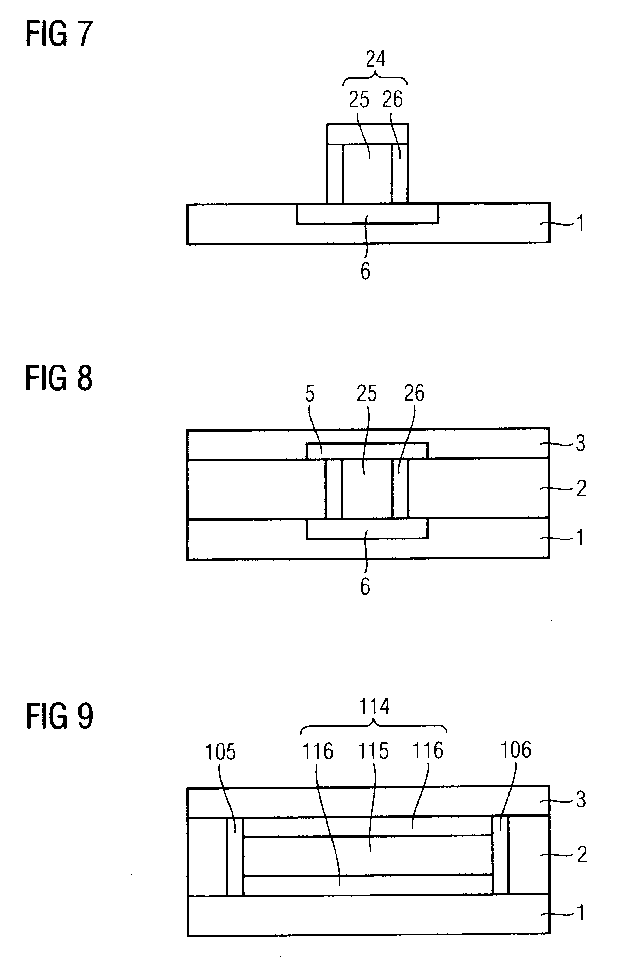

In nachfolgenden Schritten wird, falls noch notwendig, die Hartmaske 30 entfernt, die Zelle 24 in einer Füllmasse 2 eingebettet, und schließlich auf der Zelle 24 eine obere Kontaktierungsfläche 5 und eine Deckschicht 3 aufgebracht (siehe Fig. 8).

Eine weitere Ausführungsform (nicht dargestellt) der vorliegenden Erfindung sieht vor, zuerst eine chalkogenidhaltige Schicht mit einer geringen Konzentration an Verunreinigungen aufzubringen sowie diese Schicht zu strukturieren um den Kernbereich 16 einer Speicherzelle 14 zu bilden. Nachfolgend wird eine Serie oder zumindest eine weitere chalkogenidhaltigen Schicht mit steigender Konzentration an Verunreinigungen aufgebracht. Jede einzelne Schicht ist entsprechend zu strukturieren und optional das überschüssige Material auf der Deckfläche abzupolieren, um so lateral angrenzend an den Kernbereich 16 höher dotierte Randbereiche 16 anzufügen. Die Verunreinigungen können bereits während des Abscheidens oder physikalischen Deponieren der chalkogenidhaltigen Schicht in einer umgebenden Atmosphäre zugeführt werden, um entsprechend dotierte Schichten zu erhalten.

Eine weitere Ausführungsform sieht vor, die Speicherzelle 114 nicht vertikal zu dem Trägersubstrat 1 anzuordnen, sondern parallel dazu, wie in Figur 9 gezeigt. Dazu wird eine Schichtfolge an chalkogenidhaltigen Schichten aufgebracht, beginnend und endend mit einer hohen Konzentration an Verunreinigungen und wobei die Konzentration in den mittleren Schichten, welche den Kernbereich 116 bilden geringer ist. Abschließend wird wie in der ersten Ausführungsform die Schichtenfolge strukturiert um die Zelle 114 zu bilden. Im Gegensatz zu den vorhergehenden Ausführungsformen sind entsprechend Kontaktbereiche 105, 106 vertikal anzuordnen. Ein Vorteil dieses Verfahrens ist, dass es eine einfache und zuverlässige Kontrolle über das Konzentrationsprofil der Verunreinigungen in der Zelle ermöglicht, indem die Konzentration der umgebenden Atmosphäre bei der Deponierung der Schichten entsprechend erhöht bzw. verringert wird.

Obwohl die vorliegende Erfindung anhand einer bevorzugten Ausführungsform beschrieben wurde, ist sie nicht darauf beschränkt.

Insbesondere sind die Abmessungen der Kontaktbereiche 5 und 6 nur beispielhaft dargestellt. Sie können ebenso in ihrer lateralen Abmessung geringer als die Zelle 14, 24 sein.

Ebenso können andere Verfahren zum Einbringen der Verunreinigungen in das aktive Material 34 verwendet werden. Dies umfasst z.B. eine plasmaunterstützte Implantierung oder andere Implantierungstechnik aus einer Richtung 200, welche entweder senkrecht zu dem Randbereich oder unter einem Winkel zu dem Randbereich erfolgen kann.

Die Wahl der Materialien für die Kontaktbereiche umfassen Wolfram, Titannitrid, Titan, SiN, TaSiN, TiAln, TaAln und/oder Tantalnitrid. Vorteilhafterweise lassen sich somit die bereits bekannten Herstellungsverfahren zum Kontaktieren von Silizium und dotiertem Silizium auf die Kontaktierung der Chalkogenide anwenden.

Obwohl die vorliegende Erfindung mit Bezug auf eine Speichervorrichtung beschrieben wurde, ist eine Anwendung der Zelle 14, 24 auch als permanent einstellbarer Widerstand anwendbar.

### Bezugszeichenliste

- 1: Trägersubstrat
- 2: Isolationsmaterial
- 5, 6: Kontaktbereiche
- 30: Hartmaske
- 31: Photolack
- 24: Zelle
- 25: innerer Teilbereich von 24
- 26: äußerer Teilbereich von 24
- 29: Rohkörper
- 34: aktives Material
- 100: Querschnittsfläche
- 200: Richtung
- M: Mitte
- d: Breite
- p: spezifischer Widerstand
- x: horizontale Richtung

## Patentansprüche

1. Herstellungsverfahren für eine Zelle einer Speichervorrichtung, mit den folgenden Schritten:
Aufbringen und Strukturieren eines aktiven Materials (2) auf einem Trägersubstrat (1) zum Formen eines Rohkörpers (29) der Zelle (14, 24);
Einbringen von Verunreinigungen in den Rohkörper (29), derart dass eine Konzentration der Verunreinigungen in einem Randbereich (15, 25) größer als in einem Kernbereich (16, 26) des
Rohkörpers (29) ist, um aus dem Rohkörper eine Zelle (14, 24) zu bilden, welche eine verringerte spezifische elektrische
Leitfähigkeit im Randbereich (16, 26) aufweist.

2. Verfahren nach Anspruch 1,
**dadurch gekennzeichnet,**
**dass** die Konzentration der Verunreinigungen kontinuierlich vom Randbereich (15) zu dem Kernbereich (16) zunimmt.

3. Verfahren nach mindestens einem der Ansprüche 2 oder 3,
**dadurch gekennzeichnet ,**
**dass** die Verunreinigungen Sauerstoff, Stickstoff und/oder Silizium enthalten.

4. Verfahren nach mindestens einem der vorhergehenden Ansprüche,
**dadurch gekennzeichnet,**
**dass** das Einbringen durch Eindiffundieren der Verunreinigungen aus einer die Verunreinigungen enthaltenden Atmosphäre erfolgt.

5. Verfahren nach mindestens einem der vorhergehenden Ansprüche,
**dadurch gekennzeichnet ,**
**dass** die Verunreinigungen senkrecht zum Randbereich (15) oder aus einer Richtung (200) mit einem Winkel zu dem Randbereich (15) implantiert werden.

6. Verfahren nach Anspruch 4, wobei die Konzentration der Verunreinigungen in Atmosphäre während des Aufbringen des aktiven Materials (34) von einem ersten Maximalwert ausgehend bis zu einem Minimalwert verringert wird und dann bis zu einem zweiter Maximalwert wieder erhöht wird, so dass ein Kernbereich (115) eine geringere Konzentration aufweist als zuerst und zuletzt aufgebrachte Schichten des aktiven Materials (34).

7. Speichervorrichtung mit einer Zelle (14), welche in einem ersten Zustand einen hohen elektrischen Widerstand und in einem zweiten Zustand einen geringen elektrischen Widerstand aufweist, wobei die Zelle (14) einen Randbereich (15) und einen Kernbereich (16) aufweist, wobei im zweiten Zustand ein spezifischer elektrischer Widerstand (p) in dem Randbereich (15) größer als in dem Kernbereich (16) ist.

8. Vorrichtung nach Anspruch 7,
**dadurch gekennzeichnet ,**
**dass** ein aktives Material (34) der Zelle (14) in einem ersten Zustand im Kernbereich (15) amorph und in einem zweiten Zustand in der Zelle (14) kristallin ist.

9. Vorrichtung nach mindestens einem der Ansprüche 7 oder 8,
**dadurch gekennzeichnet,**
**dass** der spezifische elektrische Widerstand (p) im zweiten Zustand kontinuierlich von dem Randbereich (15) zum Kernbereich (16) zunimmt.

10. Vorrichtung nach mindestens einem der Ansprüche 7 bis 9,
**dadurch gekennzeichnet,**
**dass** der Randbereich (15) im ersten Zustand teilweise kristallin ist.

11. Vorrichtung nach mindestens einem der vorhergehenden Ansprüche 6 bis 9,
**dadurch gekennzeichnet,**
**dass** die Zelle in einer Speicherzelle (14) angeordnet ist.
